# EUROPEAN PATENT SPECIFICATION

(11) **EP 3 866 338 B1**
(45) Date of publication and mention of the grant of the patent: **06.03.2024**
(21) Application number: 20156795.5
(22) Date of filing: 12.02.2020
(51) Int. Cl.: G01R 33/09, H03M 1/78, H03F 3/45, G01R 33/00, H03F 1/30

(54) **AMPLIFIER CIRCUIT AND METHOD FOR OFFSET COMPENSATION**
VERSTÄRKERSCHALTUNG UND VERFAHREN ZUR OFFSET-KOMPENSATION
CIRCUIT D'AMPLIFICATEUR ET PROCÉDÉ DE COMPENSATION DE DÉCALAGE

(43) Date of publication of application: 18.08.2021
(73) Proprietor: TE Connectivity Sensors Germany GmbH, 44227 Dortmund (DE)
(72) Inventor: PIEPER, Reinhold, 59348 Luedinghausen (DE)
(74) Representative: Grünecker Patent- und Rechtsanwälte PartG mbB

(56) References cited:
- EP-A2- 2 221 974
- WO-A1-2004/073163
- JP-A- H 085 397
- JP-B2- 6 257 019
- US-A1- 2006 077 003
- US-A1- 2006 265 159
- US-A1- 2012 274 381
- US-A1- 2013 002 242
- US-A1- 2015 171 805
- US-A1- 2016 011 279
- US-B1- 7 313 376

## Description

The present invention relates to an active adaptive offset compensation circuit with an amplifier circuit and to a method for offset compensation. In particular, the present invention relates to the replacement of a conventional AC-amplifier by an improved chip solution that can be produced as an application specific integrated circuit (ASIC).

Highly sensitive magnetic field sensors are for instance required to detect the very weak magnetic particles contained in the color pigments of a banknote when preforming a security check of the banknote. Due to their high sensitivity and low noise anisotropic magnetoresistance (AMR) sensors may be used for this purpose. However, the electrical signals generated are still very weak. Therefore, it is necessary to amplify the signals with an amplifier to the desired amplitude. The amplification of these signals is usually about 90dB which corresponds to an amplification factor of about 31000. If a 12Bit AD converter is used, this corresponds to a resolution of approximately 25 nV / LSB at the AMR sensor.

When working with such a high gain, it is necessary to minimize the noise. A known solution here is the use of special low-noise amplifier ICs. But these are relatively expensive and lead to non-competitive solutions in the past. Also, a large printed circuit board (PCB) area is required for the realization of such an amplifier.

In order to achieve a cost-effective solution for the usually large number of measuring channels (for instance 16), a solution with discrete components and bipolar transistors was chosen in the past. Such a circuit achieves sufficient amplification and a low noise level with a good signal at favorable material prices. By using thin film resistors at critical locations, it was possible to reduce the noise to a minimum. The use of tantalum capacitors was unavoidable because multilayer ceramic capacitors showed the disadvantageous property of piezo sensitivity. Due to this effect, these capacitors would transform the structure-borne noise that passes through the sensor into electrical voltages due to mechanical deformation. These electrical voltages may contaminate the sensor signal.

In the past, the banknote line sensor arrays had a reading width of approximately 10 mm per channel. Now there are efforts on the market to increase the resolution in order to be able to resolve more magnetic details on the banknotes. Smaller magnetic security features are expected due to the increasing number of counterfeit banknotes and improved note quality among counterfeiters. With a higher resolution of the magnetic image of a banknote, the verification of the features of course has to be much more accurate.

As the number of channels increases, so does the number of amplifiers. This increase causes higher material costs and requires a lot of space to place such a high number of amplifiers. However, the installation space for such banknote sensors in a banknote validator system is limited. For example, a banknote validator system may require 56 channels with a total scan length of 98 mm. This corresponds to a resolution of 1.75 mm per channel. Conventional amplifier designs for instance use 19 components at the moment. For a 56 channel high-resolution device this would lead to 1064 components. However, such a high number of components cannot be accommodated in the usually available installation space. In addition, each new generation of banknote validators is reduced in size compared to the previous generation, i.e. even less space is available for a magnetic banknote marking sensor.

JP H08 5397 A relates to an offset cancelling device for detecting sensor. The aim which is allegedly solved is to cancel an offset voltage by detecting the switching point of the output level of a comparator for comparing the output voltage of a detector with that of an offset detector, and obtaining the difference between the detected offset voltage and the output voltage of the detector by a differential amplifier.

US 2006/077003 A1 relates to a DC offset calibration device for calibrating a DC offset of an output signal of a gain stage, the DC offset calibration device includes: a digital-to-analog converter (DAC) electrically connected to the gain stage for generating an offset current according to the DC offset of the output signal of the gain stage; and a current-to-current converter electrically connected to the DAC and the gain stage for reducing the signal scale of the offset current to generate a compensation signal so as to reduce the DC offset at the output of the gain stage.EP 2 221 974 A2 relates to amplifiers with power-on trim and methods using an amplifier system having an amplifier system input and an amplifier system output, an amplifier, a comparator, a successive approximation register having an input coupled to an output of the comparator, a first switch for switching an input of the amplifier from the amplifier system input to shorting the amplifier input, a second switch for switching an output of the amplifier from the amplifier system output to an input of the comparator, an output of the successive approximation register being coupled to an N bit DAC.

WO 2004/073163 A1 relates to self-zeroing for critical, continuous-time applications. Specifically, it relates to an apparatus for continuous-time application, comprising an operational amplifier and a self-zeroing control unit for reducing an offset of the operational amplifier. The self-zeroing control unit provides for a self-zeroing operation mode and a normal operation mode. It comprises a comparator, a successive approximation register, and a digital-to-analog converter.

US 7313376 B1 discloses a system and method for performing DC offset correction in a wireless communication receiver during "dead time". The receiver includes amplifier circuitry that amplifies a received radio frequency (RF) signal, downconversion circuitry that downconverts the received RF signal to provide a downconverted signal, digitization circuitry that digitizes the downconverted signal to provide a digital signal, and digital DC offset correction circuitry enabled during the dead time when there should be no DC content in the downconverted signal. In operation, the digital DC offset correction circuitry detects a DC offset of the digital signal and subtracts the DC offset from the digital signal.

US 2016/011279 A1 relates to a magnetic field sensor device using different types of magnetic field sensors. Devices, methods and systems are disclosed using a first magnetic field sensor of a first type and a second magnetic field sensor of a second type different from the first type.

A signal from the first sensor may be used in a first magnetic field, range, and a signal from the second sensor may be used in a second magnetic field range. JP 6 257019 B2 (SEIKO NPC CORP) 10 January 2018 discloses an AMR sensor circuit that is coupled, single-ended to an input of an opamp and a SAR-ADC/DAC based offset compensation method that quickly finds a suitable offset voltage value during calibration.

More generally, conventional amplifiers have the following disadvantages.

Conventionally constructed AC amplifiers require many components which consume a lot of installation space. The high number of components increases the risk of failure due to assembly or component faults. Capacitors are required for DC decoupling. Capacitors tend to unwanted leakage currents. Capacitors are sensitive to structure-borne noise (piezo effect) and thus generate undesirable interference signals.

Generally, magnetoresistive sensors (also referred to in this application as magnetic sensors) measure the direction of magnetic fields. Such arrangements and methods find use in the art of determining magnetic materials such as magnetic markings in banknotes, but also detecting angles and positions by means of magnetic field sensors.

The sensors make use of the magnetoresistive effect, which is the tendency of a material (e. g. ferromagnetic) to change the value of its electrical resistance in an externally applied magnetic field. In particular, in multicomponent or multilayer systems (e.g. magnetic tunnel junctions), giant magnetoresistance (GMR), tunnel magnetoresistance (TMR), colossal magnetoresistance (CMR), and extraordinary magnetoresistance (EMR) can be observed, while the anisotropic magnetoresistive effect (AMR) needs only one layer to occur.

Magnetic sensors provide an outstanding accuracy as well as a high robustness against challenging environmental conditions and play an important role in various applications such as manufacturing and transportation applications. In more detail, magnetoresistive (MR) sensors are important components because of their low intrinsic measurement error and high stability. Additionally, the favorable temperature characteristic as well as the robustness against harsh environmental conditions leads to the relevance of magnetoresistive sensors in many important applications.

In this disclosure, an electronic design is provided for a low field AMR or tunnel magnetoresistance (TMR) sensor with an amplifier and adaptive offset compensation which can be realized in an ASIC and results in a much smaller space requirement. However, the principles of the present invention may also be used with other types of sensors.

An objective of the present disclosure is an amplifier ASIC which is integrated together with a sensor element in a package, or in case of a TMR sensor, could be deposited on top of the amplifier ASIC. Usually input offset voltages are decoupled by capacitors in standard amplifier circuits. One challenge is to develop an amplifier without capacitors. In integrated circuits, only capacitors of a few pF can be realized and therefore are only applicable for high frequencies. With e. g. magnetic banknote line sensors, however, the frequency range of the useful signal lies within a bandwidth of 50 Hz to 3000 Hz. In this case it is very difficult to compensate these strongly varying offset voltages of the AMR sensor components.

The variations of the offset values have different causes: On the one hand, the component variations and tolerances in the AMR chip production (typically <3 mV/V), on the other hand, also varying magnetic misalignment angles of integrated magnets in detector systems and the mechanical installation tolerances of all sensor components and magnets lead to offset variations of several mV/V.

In order to compensate these inevitable offsets, new approaches are needed for compensation.

At least one of the above outlined objectives is solved by the subject matter of the independent claims. Advantageous embodiments of the present invention are the subject matter of the dependent claims.

In particular, the present invention is based on the idea to provide an active adaptive offset compensation circuit that adjusts the sensor output signal to almost 0 V. No capacitors are needed which cannot be produced on chip level. The offset voltage of the magnetoresistive sensor is compensated by an active circuit. The circuit compensates the offset voltages directly during startup or when activated from the outside. The circuit consists of simple circuit parts that as such are well-known to a person skilled in the art.

In more detail, the present disclosure relates to an active adaptive offset compensation circuit with a magnetoresistive sensor and an amplifier circuit comprising at least one first input terminal and at least one second input terminal for inputting an input signal to be amplified; at least one output terminal for outputting an amplified output signal; an amplifier having a first amplifier input connected to the first input terminal and a second amplifier input connected to the second input terminal, the amplifier being operable to output an amplified signal at an amplifier output; a ramp signal generator for generating a voltage ramp at a ramp signal output, wherein the ramp signal output is connected to the second amplifier input; a comparator which is connected to the amplifier output and is operable to compare the amplifier output signal to a reference voltage; and a reset unit connected to a comparator output, the reset unit being operable, in response to the amplifier output signal being equal to or smaller than the reference voltage, to stop the ramping operation of the ramp signal generator, so that the ramp signal generator is operable to hold its ramp signal output at a constant value.

Advantageously, the sensor output voltage, together with the voltage generated by the DAC, form the source for the amplifier stage, which amplifies the combined signal with an amplification of for instance about 500. From a certain point of the ramp, the differential input voltage of the amplifier is changing the polarity. This condition stops the ramp from rising and keeps the ramp voltage at the determined value and is causing a stable operating point of the amplifier. A compensation of offset voltages in the range of +/- 100mV is thus possible without problems. Since the offset voltage changes only slightly over temperature and time, such a compensation process is only necessary during start-up. Due to the high amplitude, the generated voltage can be fed directly into a 56 channel analog multiplexer circuit. The signal can easily be digitized with an ADC with appropriate pre-amplification.

Since no clock is active in the amplifier circuit after offset compensation, it can be assumed that no undesired digital interference effects occur, which could otherwise occur due to crosstalk and coupling between the various elements.

By using a constant clock and a known slope of the ramp, it is also possible to determine the offset voltage generated by the sensor. The time from the start of the ramp until the operating point is reached (t_{offset}), is a value for the offset voltage of the sensor. This offset voltage is an important measure with which the quality of the magnet system can be determined. If a high offset voltage is determined, this indicates an incorrectly tuned magnetic environment in most cases.

This high level of integration makes it for instance possible to implement high-resolution line sensors at the smallest producible installation space. This is an important step for the next generation of linear sensor arrays for applying in banknote, level, and linear applications. In addition, this approach is readily applicable to the next generation of TMR sensors, which have higher sensitivity, a higher resistance (less power consumption), and can be deposited right on the ASIC. In particular, the degree of integration can be enhanced even further by fabricating the amplifier circuit and one ore more sensor units on one common substrate and/or within one common package. Moreover, a common package may contain a plurality of amplifier circuits, optionally with an analog-to-digital-converter (ADC) and/or an analog multiplexer.

According to an advantageous example of the present disclosure, the ramp signal generator comprises a counter connected to a clock signal generator and to a digital-to-analog-converter (DAC) for converting the counter output into an analog signal, wherein the analog signal forms the ramp signal. DACs and counters are well-known, inexpensive circuit components which can easily be realized as a monolithic integrated circuit, for instance in the form of an ASIC.

It could be shown, that for instance an 8 bit counter in combination with an 8 bit DAC can be used for an efficient offset compensation with most conventional AMR sensors. As this is known to a person skilled in the art, and 8 bit counter may count up to a maximum number of 255. Thus, in combination with a clock signal, which has a frequency around 10 to 50 kHz, the offset compensation is achieved within several milliseconds.

In order to quickly stop the counting operation, the amplifier may further comprise a switch for disconnecting the clock signal from the counter, if the ramping operation is to be stopped. It has to be noted that in addition to this disconnection, it is advantageous to stop the clock signal generator completely, so that no undesired interferences may disturb the amplified measurement signal.

According to an advantageous example of the present invention, the reset unit comprises an SR flip-flop having a set terminal, a reset terminal, and an inverted output terminal, and wherein the set terminal is connected to the comparator output and the inverted output terminal is connected to a control terminal of the switch. An SR flip-flop is a well-established inexpensive component which can achieve a secure and fast stopping of the ramping operation.

In order to allow an external reset of the amplifier circuit, the amplifier circuit may further comprise a reset input terminal for inputting a reset signal to reset the amplifier circuit.

Furthermore, the amplifier circuit may comprise timing evaluation means which are operable to determine an offset time which is indicative of a time span during which the ramp signal generator outputs the voltage ramp. Advantageously, the time span from the start of the ramping operation until the stop of the ramping operation is indicative of the absolute value of the offset. In other words, the value of the offset can be calculated from the offset time because the gradient of the voltage ramp is known.

A particularly efficient and space-saving way of realizing the comparator can be achieved when the comparator comprises an open-loop differential operational amplifier, wherein a non-inverting input of the operational amplifier is connected with the reference voltage, wherein the inverting input of the operational amplifier is connected with the amplifier output, and wherein the output of the operational amplifier is connected with the reset unit.

According to a further advantageous example, the amplifier circuit further comprises an output enable switch controllable by an enable signal, wherein the amplifier circuit is operable to output the amplified output signal in response to the enable signal. Such an output enable switch allows to control whether a signal is output at the output terminal.

In particular, if the amplifier further comprises a 1-bit shift register for providing the enable signal in response to a input signal received from a data line, a daisy chained readout of the amplified output signal can be achieved when serially interconnecting a plurality of amplifier circuits. As this is known, a 1-bit shift register, also called D flip-flop, tracks the input, making transitions with match those of the input D. The D stands for "data"; the D flip-flop stores the value that is on the data line. It can be considered as a basic memory cell. A D flip-flop can be made from a set/reset flip-flop by tying the set to the reset through an inverter. The result may be clocked.

The present invention further relates to a method for offset compensation in an active adaptive offset compensation circuit with a magnetoresistive sensor and an amplifier circuit, the method comprising the following steps:
inputting an input signal to be amplified across a first input terminal and a second input terminal, wherein the amplifier circuit has an amplifier having a first amplifier input connected to the first input terminal and a second amplifier input connected to the second input terminal, the amplifier being operable to output an amplified signal at an amplifier output;
resetting a ramp signal generator to a start value and, starting from the start value, generating a voltage ramp at a ramp signal output of the ramp signal generator, outputting the voltage ramp to the second amplifier input;
by means of a comparator which is connected to the amplifier output, comparing the amplifier output signal to a reference voltage;
if the amplifier output signal is equal to or smaller than the reference voltage, stopping the ramping operation of the ramp signal generator, so that the ramp signal generator holds its ramp signal output at a constant value;
outputting an amplified output signal at an output terminal of the amplifier circuit.

Advantageously, the ramp signal generator comprises a counter connected to a clock signal generator and to a digital-to-analog-converter for converting the counter output into an analog signal, wherein the analog signal forms the ramp signal.

As mentioned above, the clock signal generator is disconnected from the counter, if the ramping operation is to be stopped. Furthermore, in order to avoid interferences, the clock signal generator may be switched off completely after the ramping operation is stopped.

In order to calculate an absolute value of the offset voltage, an offset time is determined which is indicative of a time span during which the ramp signal generator outputs the voltage ramp.

The present invention may advantageously be used with an AC amplifier, wherein the input signal comprises an alternating voltage. For instance AMR sensors may provide an alternating voltage as their output signal. However, it is clear for a person skilled in the art that the present invention may also be used in other application environments.

According to an advantageous example of the present invention, the offset compensation is performed during a start-up procedure of the amplifier circuit and/or after an external activation.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments.

Furthermore, several aspects of the embodiments may form-individually or in different combinations-solutions according to the present invention. Further features and advantages will become apparent from the following more particular description of the various embodiments of the invention as illustrated in the accompanying drawings, in which like references refer to like elements, and wherein:
- **FIG. 1**: is a schematic block diagram of an amplifier circuit according to an example of the present disclosure;
- **FIG. 2**: is a schematic circuit diagram of an amplifier circuit according to an example of the present disclosure;
- **FIG. 3**: is a schematic timing diagram of some signals occurring when operating the circuit of Fig. 2;
- **FIG. 4**: is a schematic block diagram of a daisy chain topology comprising a plurality of amplifier circuits.

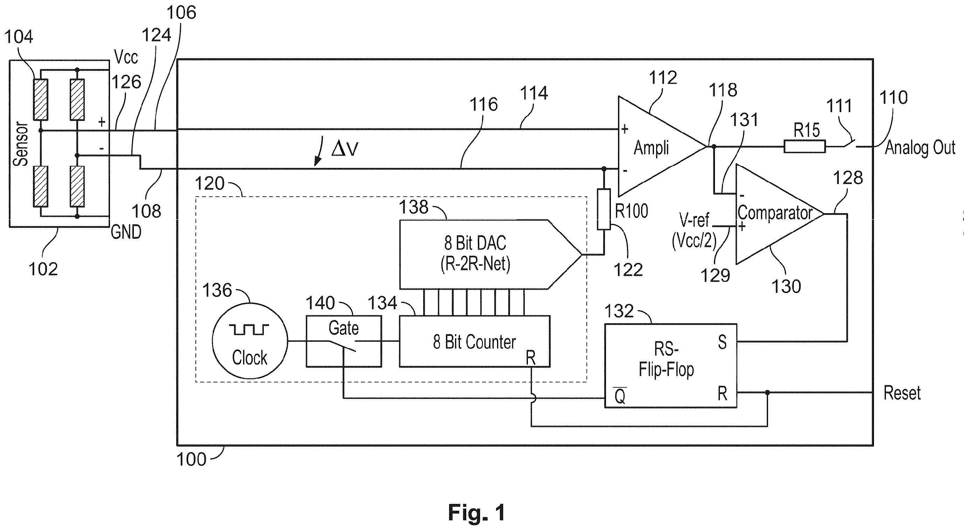

The present invention will now be explained in more detail with reference to the Figures. Referring to Fig. 1, a schematic block diagram of an AC amplifier circuit 100 connected exemplarily to an AMR sensor 102 is shown. It has to be noted that the application environment shown in Fig. 1 of course is only an example of how to use the amplifier circuit according to the present invention. Any other application where a high gain is to be achieved with an automatic offset compensation may also benefit from the amplifier circuit according to the present invention. In particular, not only AMR sensors, but also GMR, TMR, or any other kind of sensors could be used with an amplifier circuit according to the present disclosure.

As this is known in the art, the AMR sensor 102 may comprise a Wheatstone bridge configuration of four magnetoresistive plates 104. Usually, opposite elements of the bridge are chosen to be equal. Magnetoresistive sensors generally detect only changes in the magnetic field, but are insensitive to homogenous fields. Consequently, in order to detect a (ferro-) magnetic marking on a banknote, an alternating magnetic field is applied to the marking and the AMR sensor picks up an alternating response signal, depending on the presence or absence of the marking.

The amplifier circuit 100 comprises a first input terminal 106 and a second input terminal 108. An output terminal 110 is provided for outputting the amplified and compensated output signal.

An amplifier 112 is connected with the first input terminal 106 and the second input terminal 108, so that the sensor signal is applied across the first amplifier input 114 and the second amplifier input 116. An amplifier output 118 is connected to the output terminal 110 via a resistor R15. Optionally, a controlled switch 111 can be provided. This switch 111 serves as an output enable means and a terminal for controlling the switch 111 can be accessible from the outside as an enable pin (not shown in the Figure).

According to the present disclosure, a ramp signal generator 120 is provided, which generates a voltage ramp at a ramp signal output 122. The ramp signal output 122 is connected to the negative input 116 of the amplifier 112 via a resistor R100. Thus, the ramp voltage is overlaid with the sensor signal.

In the shown example, the second input terminal 108 is connected with a negative output terminal 124 of the AMR sensor 102. The first input terminal 106 is connected with a positive output terminal 126 of the AMR sensor 102, so that an output signal ΔV is applied across the input terminals 114, 116 of the amplifier 112. If the ramp voltage starts with 0 V, a large voltage at the differential input 114, 116 of the amplifier 112 is effective when the ramp voltage starts ramping up. The amplifier 112 is outside its operating point and the output 118 of the amplifier 112 is at high level Vcc. Due to the continuously increasing voltage at the output of the ramp signal generator 120, however, the voltage at the differential input 114, 116 of the amplifier 112 decreases.

The polarity of the differential output signal ΔV of the AMR sensor 102 reaches a point where the polarity of the differential voltage ΔV reverses. From this point on, the output voltage at the output 118 of the amplifier 112 changes to a value lower than Vref. This then causes a voltage change at the output 128 of the comparator 130. As a result, a reset unit, e. g. an SR flip-flop 132, is actuated to switch off the ramping operation of the ramp signal generator 120. The ramp signal generator 120 holds its output voltage value, so that a continuous offset correction is performed during the regular operation that is now following. From this point on, the amplifier circuit 100 operates in a stable range and can output the useful signal correctly at the output terminal 110.

Figure 1 shows a particular example of a ramp signal generator 120 comprising a counter 134 which is provided with a clock signal from a clock signal generator 136. Alternatively, the clock signal may also be received from an external source such as a host microcontroller, if the amplifier circuit is part of a larger sensor system. The counter output is input into a digital-to-analog converter (DAC) 138. The DAC 138 generates the ramp voltage from the counter output.

In the shown example, the comparator 130 is an open loop operational amplifier which at its positive comparator input 129 receives a reference voltage Vref, for instance Vcc/2. The negative comparator input 131 is connected to the amplifier output 118.

In order to quickly stop the counting operation as soon as the stable operation point of the amplifier 112 is reached, a controllable switch 140 is provided which disconnects the clock signal generator 136 from the counter 134 as soon as the inverted output Q‾ of the SR flip-flop changes to a HIGH value.

According to the present disclosure, the clock signal is immediately and permanently switched off. The counter 134 keeps its value and generates together with the DAC 138 the necessary compensation offset voltage to guarantee a stable operating point of the amplifier 112.

Furthermore, a reset input terminal 133 is provided for inputting an external reset signal to reset the amplifier circuit 100.

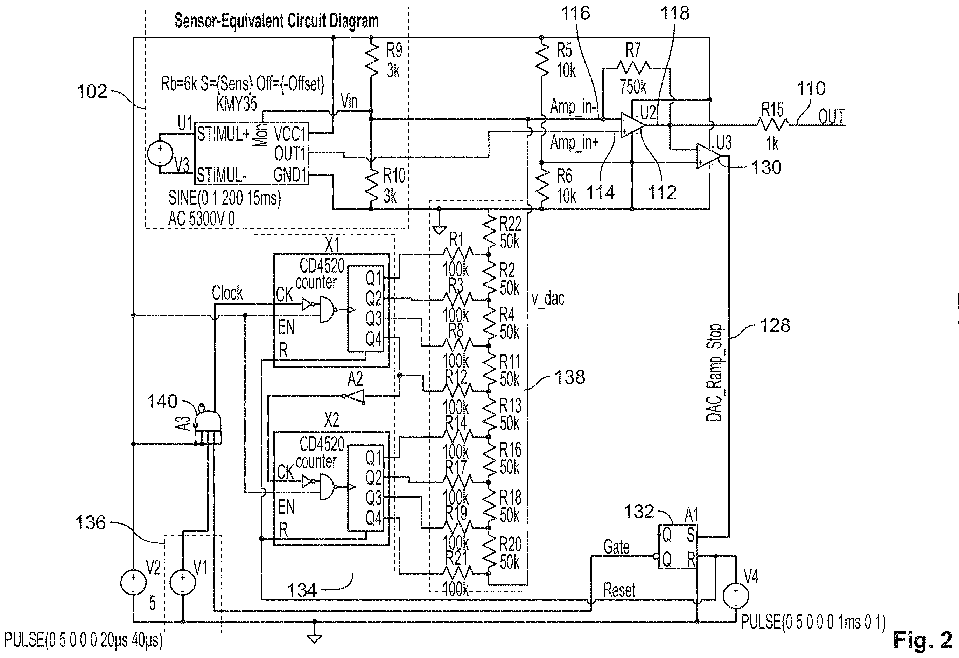

Fig. 2 illustrates an exemplary circuit diagram of an AC amplifier circuit 100 according to the present disclosure. The AMR sensor 102 is represented by an equivalent circuit. The counter 134 exemplarily is formed as an 8 bit counter and the DAC 138 correspondingly is an 8 bit DAC. The switch 140 comprises a gate that allows to disconnect the clock from the counter 134.

It has to be noted that all values given in Fig. 2 are of course only exemplary and can be varied as this might be needed for different application environments. Moreover, apart from the illustrated AMR sensor 102, of course, also any other input signal that has to be amplified with a high gain and accuracy can be amplified with the amplifier circuit according to the present disclosure.

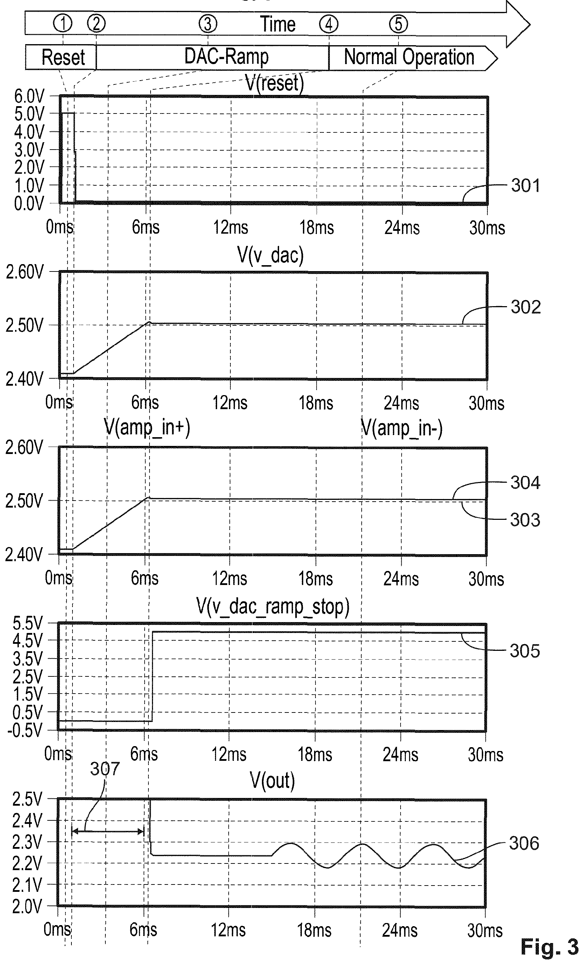

Fig. 3 illustrates timing diagrams of the most relevant voltages occurring in the amplifier circuit 100 as shown in Fig. 2.

In particular, curve 301 depicts the reset pulse which is emitted for a duration of about 1 ms for resetting the counter controlling the DAC to 0 (point (D). As soon as the reset voltage goes back to LOW level again (point ②), the ramping up of the voltage at the output of the DAC starts. This can be seen from curve 302. Interval ③) indicates the duration of the voltage ramp.

In the third diagram, the two input voltages at the amplifier are shown: curve 303 shows the constant high input at the positive input of the amplifier and curve 304 shows the voltage at the negative input of the amplifier, being the ramp signal output by the DAC during the ramping interval ③).

The ramping interval ③ ends as soon as the curve 304 reaches the reference voltage Vref (which in the present case is half of Vcc, here exemplarily 2.5 V). This instance is marked as point ④. As can be seen from curve 305, the signal V(dac_ramp_stop) that stops the counting operation takes a HIGH value at point ④.

The lowermost diagram shows as curve 306 the output signal V(out) at the output terminal of the amplifier circuit. Until the end of the ramping operation, the signal V(out) is outside a stable range. Starting from point @, the amplifier operates in a stable range and can output the useful signal V(out) correctly.

Interval ⑤ signifies the normal operation of the amplifier circuit.

By monitoring the time t_{offset} it takes until the ramping operation is ended (see interval 307), the value of the offset voltage can be calculated and for instance output to a user. The offset voltage is an important measure with which the quality of the magnet system can be determined. If a high offset voltage is determined, this indicates an incorrectly tuned magnetic environment in most cases.

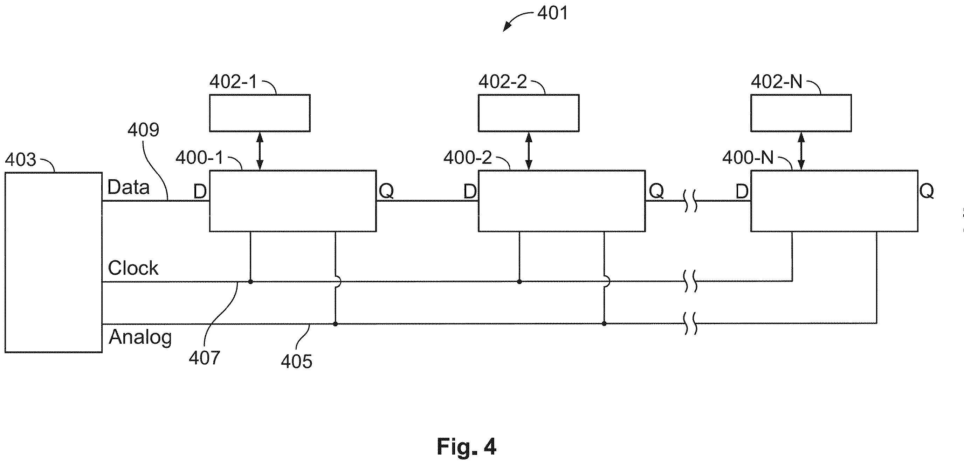

Fig. 4 illustrates an advantageous sensor system 401 comprising a plurality of amplifier circuits 400-1, 400-2, ... 400-N, N being an integer. Such a sensor system 401 may for instance be used as a linear magnetic sensor array for detecting safety features on documents such as banknotes.

Each of the amplifier circuits 400-1, 400-2, ... 400-N is connected to a sensor circuit 402-1, 402-2, ... 402-N, respectively. The sensor system 401 comprises a host 403, which is for instance formed by a microcontroller. The amplifier circuits 400-1, 400-2, ... 400-N each comprise a 1-bit shift register (not visible in the Figure) with in input terminal D and an output terminal Q accessible from the outside. As this is generally known, a 1-bit shift register, also called D flip-flop, tracks the input, making transitions with match those of the input D. The D stands for "data"; the D flip-flop stores the value that is on the data line. It can be considered as a basic memory cell. A D flip-flop can be made from a set/reset flip-flop by tying the set to the reset through an inverter. The result may be clocked.

Advantageously, each of the amplifier circuits 400-1, 400-2, ... 400-N has an enable function, for instance a switch 111 as shown in Fig. 1. This switch is controlled by the output of the 1-bit shift register, so that whenever the 1-bit shift register is activated, the sensor signal of the respective amplifier circuit is output to the bus line 405 to be received by the host 403.

A clock line 407 provides all amplifier circuits 400-1, 400-2, ... 400-N with a clock signal output by the host 403. Via the data line 409 the host 403 activates the amplifier circuits 400-1, 400-2, ... 400-N e. g. by emitting a single pulse. This pulse is passed through each of the 1-bit shift registers in the amplifier circuits 400-1, 400-2, ... 400-N, thereby sequentially activating the amplifier circuits 400-1, 400-2, ... 400-N to output the signal representing a measurement value of the belonging sensor circuit 402-1, 402-2, ... 402-N. Consequently, the sensor system 401 allows a sequential sensor readout with only three lines.

It goes without saying that particular parts or even all components of the sensor system 401 can be realized as an integrated component within a common package and/or on a common substrate.

In summary, the present invention may provide an amplifier circuit wherein the sensor output voltage, together with the voltage generated by the DAC form the source for the amplifier stage, which amplifies the AC signal with an amplification of about 500. From a certain point of the ramp, the differential input voltage of the amplifier is changing the polarity. This condition stops the ramp from rising and keeps the ramp voltage at the determined value and is causing a stable operating point of the amplifier. A compensation of offset voltages in the range of +/- 100mV is thus possible without problems.

Since the offset voltage changes only slightly over temperature and time, such a compensation process is only necessary during start-up. Due to the high amplitude, the generated voltage can be fed directly into a 56 channel analog multiplexer circuit. The signal can easily be digitized with an ADC with appropriate pre-amplification.

Since no clock is active in the amplifier circuit after offset compensation, it can be assumed that no negative digital interference effects occur, which could otherwise occur due to crosstalk and coupling between the various elements.

By using a constant clock and a known slope of the ramp, it is also possible to determine the offset voltage generated by the sensor. The time from the start of the ramp until the operating point is reached (t_{offset}), is a value for the offset voltage of the sensor. This offset voltage is an important measure with which the quality of the magnet system can be determined. If a high offset voltage is determined, this indicates an incorrectly tuned magnetic environment in most cases.

This high level of integration makes it possible to implement high-resolution line sensors at the smallest producible installation space. This is an important step for the next generation of linear sensor arrays for applying in banknote, level and linear applications. In addition, this approach is readily applicable to the next generation of TMR sensors, while have higher sensitivity, at higher resistance (less power consumption) and can be deposited right on the ASIC.

### REFERENCE NUMERALS

| **Reference Numeral** | **Description** |
|---|---|
| 100; 400-1, 400-2, 400-N | AC amplifier circuit |
| 102; 402-1, 402-2, 402-N | Sensor circuit |
| 104 | Magnetoresistive plate |
| 106 | First input terminal |
| 108 | Second input terminal |
| 110 | Output terminal |
| 111 | Optional switch |
| 112 | Amplifier |
| 114 | First amplifier input |
| 116 | Second amplifier input |
| 118 | Amplifier output |
| 120 | Ramp signal generator |
| 122 | Ramp signal output |
| 124 | Negative output terminal |
| 126 | Positive output terminal |
| 128 | Comparator output |
| 129 | Positive comparator input |
| 130 | Comparator |
| 131 | Negative comparator input |
| 132 | Reset unit; SR flip-flop |
| 133 | Reset input terminal |
| 134 | Counter |
| 136 | Clock signal generator |
| 138 | Digital-to-analog converter (DAC) |
| 140 | Switch; gate |
| 301 | Timing curve of V(reset) |
| 302 | Timing curve of V(v_dac) |
| 303 | Timing curve of V(amp_in+) |
| 304 | Timing curve of V(amp_in-) |
| 305 | Timing curve of V(dac_ramp_stop) |
| 306 | Timing curve of V(out) |
| 307 | Offset time |
| 401 | Sensor system |
| 403 | Host |
| 405 | Analog bus line |
| 407 | Clock line |
| 409 | Data line |

## Claims

1. Active adaptive offset compensation circuit configured to compensate an offset voltage of a magnetoresistive sensor (102), the circuit comprising an amplifier circuit (100) and the magnetoresistive sensor (102), the amplifier circuit (100) comprising:
a first input terminal (106) and a second input terminal (108) for inputting a differential input signal from the magnetoresistive sensor (102) to be amplified;
an output terminal (110) for outputting an amplified output signal;
an amplifier (112) having a first amplifier input (114) connected to the first input terminal (106) and a second amplifier input (116) connected to the second input terminal (108), the amplifier (112) being operable to output an amplified signal at an amplifier output (118),
wherein the amplifier output (118) is connected to the output terminal (110);
a ramp signal generator (120) for generating a voltage ramp at a ramp signal output (122), wherein the ramp signal output (122) is connected to the second amplifier input (116);
a comparator (130) which is connected to the amplifier output (118) and is operable to compare the amplifier output signal to a constant reference voltage (Vref);
a reset unit (132) connected to a comparator output (128), the reset unit (132) being operable, in response to the amplifier output signal being equal to or smaller than the reference voltage (Vref), to stop the ramping operation of the ramp signal generator (120), so that the ramp signal generator (120) is operable to hold its ramp signal output (122) at a constant value, causing a stable operating point of the amplifier (112) and a compensation of the offset voltage of said magnetoresistive sensor (102).

2. Circuit according to claim 1, wherein the ramp signal generator (120) comprises a counter (134) connected to a clock signal generator (136) and to a digital-to-analog-converter (138) for converting the counter output into an analog signal, wherein the analog signal forms the ramp signal.

3. Circuit according to claim 2, wherein the counter (134) comprises an 8 Bit counter and the digital-to-analog-converter (138) comprises an 8 Bit digital-to-analog-converter.

4. Circuit according to claim 2 or 3, further comprising a switch (140) for disconnecting the clock signal from the counter (134), if the ramping operation is to be stopped.

5. Circuit according to claim 4, wherein the reset unit (132) comprises an SR flip-flop having a set terminal (S), a reset terminal (R), and an inverted output terminal (Q̅), and wherein the set terminal (S) is connected to the comparator output (128) and the inverted output terminal (Q‾) is connected to a control terminal of the switch (140).

6. Circuit according to one of the preceding claims, further comprising a reset input terminal (133) for inputting an external reset signal to reset the switch (140) and the reset unit (132), the reset signal causing a restart of the voltage ramp generation in the ramp signal generator (120), and further comprising timing evaluation means which are operable to determine an offset time, the offset time is indicative of a time span during which the ramp signal generator (120) outputs the voltage ramp, wherein the offset time is used to calculate the offset voltage.

7. Circuit according to one of the preceding claims, wherein the comparator (130) comprises an open-loop differential operational amplifier, wherein a non-inverting input of the operational amplifier is connected with the reference voltage (Vref), wherein the inverting input of the operational amplifier is connected with the amplifier output (118), and wherein the output of the operational amplifier is connected with the reset unit (132).

8. Method for compensating an offset voltage of a magnetoresistive sensor (102) in an active adaptive offset compensation circuit comprising an amplifier circuit (100) and the magnetoresistive sensor (102), the method comprising the following steps:
inputting a differential input signal from a magnetoresistive sensor (102) to be amplified across a first input terminal (106) and a second input terminal (108), wherein the amplifier circuit (100) has an amplifier (112) having a first amplifier input (114) connected to the first input terminal (106) and a second amplifier input (116) connected to the second input terminal (108), the amplifier (112) being operable to output an amplified signal at an amplifier output (118);
resetting a ramp signal generator (120) to a start value and, starting from the start value, generating a voltage ramp at a ramp signal output (122) of the ramp signal generator (120), outputting the voltage ramp to the second amplifier input (116);
by means of a comparator (130) which is connected to the amplifier output (118), comparing the amplifier output signal to a constant reference voltage (Vref);
if the amplifier output signal is equal to or smaller than the reference voltage (Vref), stopping the ramping operation of the ramp signal generator (120) by means of a reset unit (132) that is connected to a comparator output (128), so that the ramp signal generator holds its ramp signal output (122) at a constant value, causing a stable operating point of the amplifier (112) and a compensation of the offset voltage of said magnetoresistive sensor (102);
outputting the amplified signal at an output terminal (110) of the amplifier circuit (100).

9. Method according to claim 8, wherein the ramp signal generator (120) comprises a counter (134) connected to a clock signal generator (136) and to a digital-to-analog-converter (138) for converting the counter output into an analog signal, wherein the analog signal forms the ramp signal.

10. Method according to claim 9, wherein the clock signal generator (136) is disconnected from the counter (134), if the ramping operation is to be stopped.

11. Method according to claim 10, wherein the clock signal generator (136) is switched off completely after the ramping operation is stopped.

12. Method according to one of the claims 8 to 11, wherein an offset time is determined which is indicative of a time span during which the ramp signal generator (120) outputs the voltage ramp, and/or wherein the input signal comprises an alternating voltage.

13. Method according to one of the claims 8 to 12, wherein the offset compensation is performed during a start-up procedure of the amplifier circuit (100) and/or after an external activation.

## Patentansprüche

1. Aktive adaptive Offsetkompensationsschaltung, die so konfiguriert ist, dass sie eine Offsetspannung eines magnetoresistiven Sensors (102) kompensiert, wobei die Schaltung eine Verstärkerschaltung (100) und den magnetoresistiven Sensor (102) umfasst, wobei die Verstärkerschaltung (100) Folgendes umfasst:
einen ersten Eingangsanschluss (106) und einen zweiten Eingangsanschluss (108) zum Eingeben eines zu verstärkenden differentiellen Eingangssignals vom magnetoresistiven Sensor (102);
einen Ausgangsanschluss (110) zur Ausgabe eines verstärkten Ausgangssignals;
einen Verstärker (112) mit einem ersten Verstärkereingang (114), der mit dem ersten Eingangsanschluss (106) verbunden ist, und einem zweiten Verstärkereingang (116), der mit dem zweiten Eingangsanschluss (108) verbunden ist, wobei der Verstärker (112) betreibbar ist, um ein verstärktes Signal an einem Verstärkerausgang (118) auszugeben, wobei der Verstärkerausgang (118) mit dem Ausgangsanschluss (110) verbunden ist;
einen Rampensignalgenerator (120) zum Erzeugen einer Spannungsrampe an einem Rampensignalausgang (122), wobei der Rampensignalausgang (122) mit dem zweiten Verstärkereingang (116) verbunden ist;
einen Komparator (130), der mit dem Verstärkerausgang (118) verbunden ist und so betrieben werden kann, dass er das Verstärkerausgangssignal mit einer konstanten Referenzspannung (Vref) vergleicht;
eine Rücksetzeinheit (132), die mit einem Komparatorausgang (128) verbunden ist, wobei die Rücksetzeinheit (132) als Reaktion darauf, dass das Verstärkerausgangssignal gleich oder kleiner als die Referenzspannung (Vref) ist, betreibbar ist, um den Rampenbetrieb des Rampensignalgenerators (120) zu stoppen, so dass der Rampensignalgenerator (120) betreibbar ist, um seinen Rampensignalausgang (122) auf einem konstanten Wert zu halten, was einen stabilen Arbeitspunkt des Verstärkers (112) und eine Kompensation der Offsetspannung des magnetoresistiven Sensors (102) bewirkt.

2. Schaltung nach Anspruch 1, wobei der Rampensignalgenerator (120) einen Zähler (134) umfasst, der mit einem Taktsignalgenerator (136) und einem Digital-Analog-Wandler (138) zur Umwandlung des Zählerausgangs in ein analoges Signal verbunden ist, wobei das analoge Signal das Rampensignal bildet.

3. Schaltung nach Anspruch 2, wobei der Zähler (134) einen 8-Bit-Zähler und der Digital-Analog-Wandler (138) einen 8-Bit-Digital-Analog-Wandler umfasst.

4. Schaltung nach Anspruch 2 oder 3, ferner mit einem Schalter (140) zum Trennen des Taktsignals vom Zähler (134), wenn der Rampenbetrieb gestoppt werden soll.

5. Schaltung nach Anspruch 4, wobei die Rücksetzeinheit (132) ein SR-Flipflop mit einem Setzanschluss (S), einem Rücksetzanschluss (R) und einem invertierten Ausgangsanschluss (Q̅) umfasst, und wobei der Setzanschluss (S) mit dem Komparatorausgang (128) verbunden ist und der invertierte Ausgangsanschluss (Q̅) mit einem Steueranschluss des Schalters (140) verbunden ist.

6. Schaltung nach einem der vorhergehenden Ansprüche, ferner umfassend einen Rücksetz-Eingangsanschluss (133) zum Eingeben eines externen Rücksetzsignals, um den Schalter (140) und die Rücksetzeinheit (132) zurückzusetzen, wobei das Rücksetzsignal einen Neustart der Spannungsrampenerzeugung in dem Rampensignalgenerator (120) bewirkt, und ferner umfassend Zeitauswertungsmittel, die betreibbar sind, um eine Offset-Zeit zu bestimmen, wobei die Offset-Zeit eine Zeitspanne angibt, während der der Rampensignalgenerator (120) die Spannungsrampe ausgibt, wobei die Offset-Zeit zur Berechnung der Offset-Spannung verwendet wird.

7. Schaltung nach einem der vorhergehenden Ansprüche, wobei der Komparator (130) einen Open-Loop-Differenz-Operationsverstärker umfasst, wobei ein nicht-invertierender Eingang des Operationsverstärkers mit der Referenzspannung (Vref) verbunden ist, wobei der invertierende Eingang des Operationsverstärkers mit dem Verstärkerausgang (118) verbunden ist, und wobei der Ausgang des Operationsverstärkers mit der Rücksetzeinheit (132) verbunden ist.

8. Verfahren zur Kompensation einer Offsetspannung eines magnetoresistiven Sensors (102) in einer aktiven adaptiven Offsetkompensationsschaltung, die eine Verstärkerschaltung (100) und den magnetoresistiven Sensor (102) umfasst, wobei das Verfahren die folgenden Schritte umfasst:
Eingeben eines Differenzeingangssignals von einem magnetoresistiven Sensor (102), das über einen ersten Eingangsanschluss (106) und einen zweiten Eingangsanschluss (108) zu verstärken ist, wobei die Verstärkerschaltung (100) einen Verstärker (112) mit einem ersten Verstärkereingang (114), der mit dem ersten Eingangsanschluss (106) verbunden ist, und einem zweiten Verstärkereingang (116), der mit dem zweiten Eingangsanschluss (108) verbunden ist, aufweist, wobei der Verstärker (112) betreibbar ist, um ein verstärktes Signal an einem Verstärkerausgang (118) auszugeben;
Rücksetzen eines Rampensignalgenerators (120) auf einen Startwert und, ausgehend von dem Startwert, Erzeugen einer Spannungsrampe an einem Rampensignalausgang (122) des Rampensignalgenerators (120), Ausgeben der Spannungsrampe an den zweiten Verstärkereingang (116);
mit Hilfe eines Komparators (130), der mit dem Verstärkerausgang (118) verbunden ist Vergleichen des Verstärkerausgangssignals mit einer konstanten Referenzspannung (Vref);
wenn das Ausgangssignal des Verstärkers gleich oder kleiner als die Referenzspannung (Vref) ist, Anhalten des Rampenbetriebs des Rampensignalgenerators (120) mittels einer Rücksetzeinheit (132), die mit einem Komparatorausgang (128) verbunden ist, so dass der Rampensignalgenerator seinen Rampensignalausgang (122) auf einem konstanten Wert hält, was einen stabilen Arbeitspunkt des Verstärkers (112) und eine Kompensation der Offsetspannung des magnetoresistiven Sensors (102) bewirkt;
Ausgabe des verstärkten Signals an einem Ausgangsanschluss (110) der Verstärkerschaltung (100).

9. Verfahren nach Anspruch 8, wobei der Rampensignalgenerator (120) einen Zähler (134) umfasst, der mit einem Taktsignalgenerator (136) und mit einem Digital-Analog-Wandler (138) zur Umwandlung des Zählerausgangs in ein analoges Signal verbunden ist, wobei das analoge Signal das Rampensignal bildet.

10. Verfahren nach Anspruch 9, wobei der Taktsignalgenerator (136) vom Zähler (134) getrennt wird, wenn der Rampenbetrieb gestoppt werden soll.

11. Verfahren nach Anspruch 10, wobei der Taktsignalgenerator (136) nach Beendigung des Rampenbetriebs vollständig abgeschaltet wird.

12. Verfahren nach einem der Ansprüche 8 bis 11, wobei eine Offset-Zeit bestimmt wird, die eine Zeitspanne angibt, während der der Rampensignalgenerator (120) die Spannungsrampe ausgibt, und/oder wobei das Eingangssignal eine Wechselspannung umfasst.

13. Verfahren nach einem der Ansprüche 8 bis 12, wobei die Offsetkompensation während eines Startvorgangs der Verstärkerschaltung (100) und/oder nach einer externen Aktivierung durchgeführt wird.

## Revendications

1. Circuit actif de compensation adaptative de décalage configuré pour compenser une tension de décalage d'un capteur magnétorésistif (102), le circuit comprenant un circuit amplificateur (100) et le capteur magnétorésistif (102), le circuit amplificateur (100) comprenant :
une première borne d'entrée (106) et une seconde borne d'entrée (108) destinées à recevoir en entrée un signal d'entrée différentiel à amplifier provenant du capteur magnétorésistif (102),
une borne de sortie (110) destinée à délivrer en sortie un signal de sortie amplifié,
un amplificateur (112) possédant une première entrée d'amplificateur (114) reliée à la première borne d'entrée (106) et une seconde entrée d'amplificateur (116) reliée à la seconde borne d'entrée (108), l'amplificateur (112) pouvant être utilisé pour délivrer en sortie un signal amplifié sur une sortie d'amplificateur (118), la sortie d'amplificateur (118) étant reliée à la borne de sortie (110),
un générateur de signal en rampe (120) destiné à générer une rampe de tension sur une sortie de signal en rampe (122), la sortie de signal en rampe (122) étant reliée à la seconde entrée d'amplificateur (116),
un comparateur (130) qui est relié à la sortie d'amplificateur (118) et qui peut être utilisé pour comparer le signal de sortie d'amplificateur à une tension de référence (Vref) constante,
une unité de réinitialisation (132) reliée à une sortie du comparateur (128), l'unité de réinitialisation (132) pouvant être utilisée, en réponse à ce que le signal de sortie d'amplificateur est inférieur ou égal à la tension de référence (Vref), pour stopper l'opération d'évolution progressive du générateur de signal en rampe (120) de sorte à ce que le générateur de signal en rampe (120) puisse être utilisé pour maintenir sa sortie de signal en rampe (122) à une valeur constante, ce qui amène un point de fonctionnement stable de l'amplificateur (112) et une compensation de la tension de décalage dudit capteur magnétorésistif (102).

2. Circuit selon la revendication 1, dans lequel le générateur de signal en rampe (120) comprend un compteur (134) relié à un générateur de signal d'horloge (136) et à un convertisseur numérique vers analogique (138) destiné à convertir la sortie du compteur en un signal analogique, le signal analogique formant le signal en rampe.

3. Circuit selon la revendication 2, dans lequel le compteur (134) comporte un compteur sur huit bits et le convertisseur numérique vers analogique (138) comporte un convertisseur numérique vers analogique sur huit bits.

4. Circuit selon la revendication 2 ou la revendication 3, comprenant en outre un commutateur (140) destinée à déconnecter le signal d'horloge du compteur (134) si l'opération d'évolution progressive doit être stoppée.

5. Circuit selon la revendication 4, dans lequel l'unité de réinitialisation (132) comprend une bascule RS comportant une borne de positionnement (S), une borne de réinitialisation (R) et une borne de sortie inversée (*Q̅*), et dans lequel la borne de positionnement (S) est reliée à la sortie du comparateur (128) et la borne de sortie inversée (*Q̅*) est reliée à une borne de commande du commutateur (140).

6. Circuit selon l'une des revendications précédentes, comprenant en outre une borne d'entrée de réinitialisation (133) permettant de recevoir en entrée un signal externe de réinitialisation pour réinitialiser le commutateur (140) et l'unité de réinitialisation (132), le signal de réinitialisation provoquant un redémarrage de la génération de rampe de tension dans le générateur de signal en rampe (120), et comprenant en outre un moyen d'évaluation de synchronisation qui peut être mis en œuvre pour déterminer une durée de décalage, la durée de décalage indiquant un intervalle de temps pendant lequel le générateur de signal en rampe (120) délivre la rampe de tension, la durée de décalage étant utilisée pour calculer la tension de décalage.

7. Circuit selon l'une des revendications précédentes, dans lequel le comparateur (130) comprend un amplificateur opérationnel différentiel en boucle ouverte, l'entrée non inverseuse de l'amplificateur opérationnel étant reliée à la tension de référence (Vref), l'entrée inverseuse de l'amplificateur opérationnel étant reliée à la sortie de l'amplificateur (118), et la sortie de l'amplificateur opérationnel étant reliée à l'unité de réinitialisation (132) .

8. Procédé de compensation d'une tension de décalage d'un capteur magnétorésistif (102) dans un circuit actif de compensation adaptative de décalage comprenant un circuit amplificateur (100) et le capteur magnétorésistif (102), le procédé comprenant les étapes suivantes :
l'application en entrée d'un signal d'entrée différentiel à amplifier provenant d'un capteur magnétorésistif (102) aux bornes d'une première borne d'entrée (106) et d'une seconde borne d'entrée (108), le circuit amplificateur (100) comportant un amplificateur (112) possédant une première entrée d'amplificateur (114) reliée à la première borne d'entrée (106) et une seconde entrée d'amplificateur (116) reliée à la seconde borne d'entrée (108), l'amplificateur (112) pouvant être utilisé pour délivrer en sortie un signal amplifié sur une sortie d'amplificateur (118),
la réinitialisation d'un générateur de signal en rampe (120) à une valeur de départ et, en débutant de la valeur de départ, la génération d'une rampe de tension sur une sortie de signal en rampe (122) du générateur de signal en rampe (120), la délivrance en sortie de la rampe de tension sur la seconde entrée d'amplificateur (116),
au moyen d'un comparateur (130) qui est relié à la sortie d'amplificateur (118), la comparaison du signal de sortie d'amplificateur à une tension de référence (Vref) constante,
si le signal de sortie d'amplificateur est inférieur ou égal à la tension de référence (Vref), l'arrêt de l'opération d'évolution progressive du générateur de signal en rampe (120) au moyen d'une unité de réinitialisation (132) qui est reliée à une sortie de comparateur (128) de sorte à ce que le générateur de signal en rampe maintienne sa sortie de signal en rampe (122) à une valeur constante, ce qui provoque un point de fonctionnement stable de l'amplificateur (112) et une compensation de la tension de décalage dudit capteur magnétorésistif (102),
la délivrance en sortie du signal amplifié sur une borne de sortie (110) du circuit amplificateur (100).

9. Procédé selon la revendication 8, dans lequel le générateur de signal en rampe (120) comprend un compteur (134) relié à un générateur de signal d'horloge (136) et à un convertisseur numérique vers analogique (138) destiné à convertir la sortie du compteur en un signal analogique, le signal analogique formant le signal en rampe.

10. Procédé selon la revendication 9, dans lequel le générateur de signal en rampe (120) est déconnecté du compteur (134) si l'opération d'évolution progressive doit être stoppée.

11. Procédé selon la revendication 10, dans lequel le générateur de signal d'horloge (136) est coupé complètement après que l'opération d'évolution progressive a été stoppée.

12. Procédé selon l'une des revendications 8 à 11, dans lequel une durée de décalage est déterminée, laquelle indique un intervalle de temps pendant lequel le générateur de signal en rampe (120) délivre en sortie la rampe de tension, et/ou dans lequel le signal d'entrée comprend une tension alternative.

13. Procédé selon l'une des revendications 8 à 12, dans lequel la compensation de décalage est effectuée pendant une procédure de démarrage du circuit amplificateur (100) et/ou après une activation extérieure.
